# DEMANDE DE BREVET EUROPEEN

(11) **EP 0 821 451 A1**
(43) Date de publication de la demande: **28.01.1998**
(21) Numéro de dépôt: 97401787.3
(22) Date de dépôt: 24.07.1997
(51) Int. Cl.: H01S 3/06

(54) **Microlaser solide, à pompage optique par laser semi-conducteur à cavité verticale**

(30) Priorité: 26.07.1996 FR 9609437
(71) Demandeur: COMMISSARIAT A L'ENERGIE ATOMIQUE, 75015 Paris Cédex 15 (FR)
(72) Inventeur: Thony, Philippe, 38500 La Buisse (FR); Molva, Engin, 38000 Grenoble (FR); Aubert, Jean-Jacques, 38360 Sassenage (FR); Labrunie, Guy, 38330 Saint-Ismier (FR)
(74) Mandataire: Dubois-Chabert, Guy

(57) **Abrégé**

L'invention concerne un microlaser comportant un milieu actif solide, un miroir d'entrée (52) et un miroir de sortie (54), et des moyens de pompage comportant au moins un laser semi-conducteur à cavité verticale (56).

## Description

### Domaines techniques et art antérieur

L'invention concerne le domaine des microlasers ou encore des cavités microlasers, dont le milieu actif est solide.

Les microlasers ont de nombreuses applications, dans des domaines aussi variés que l'industrie automobile, l'environnement, l'instrumentation scientifique, la télémétrie.

La structure d'un microlaser est celle d'un empilement de multicouches.

Le milieu actif laser est constitué par un matériau de faible épaisseur (entre 150-1000 µm) et de petites dimensions (quelques mm²), sur lequel des miroirs diélectriques de cavité sont directement déposés. Ce milieu actif peut être pompé par une diode laser III-V qui est soit directement hybridée sur le microlaser, soit couplée à ce dernier par fibre optique. La possibilité d'une fabrication collective utilisant les moyens de la microélectronique autorise une production de masse de ces microlasers à très faible coût.

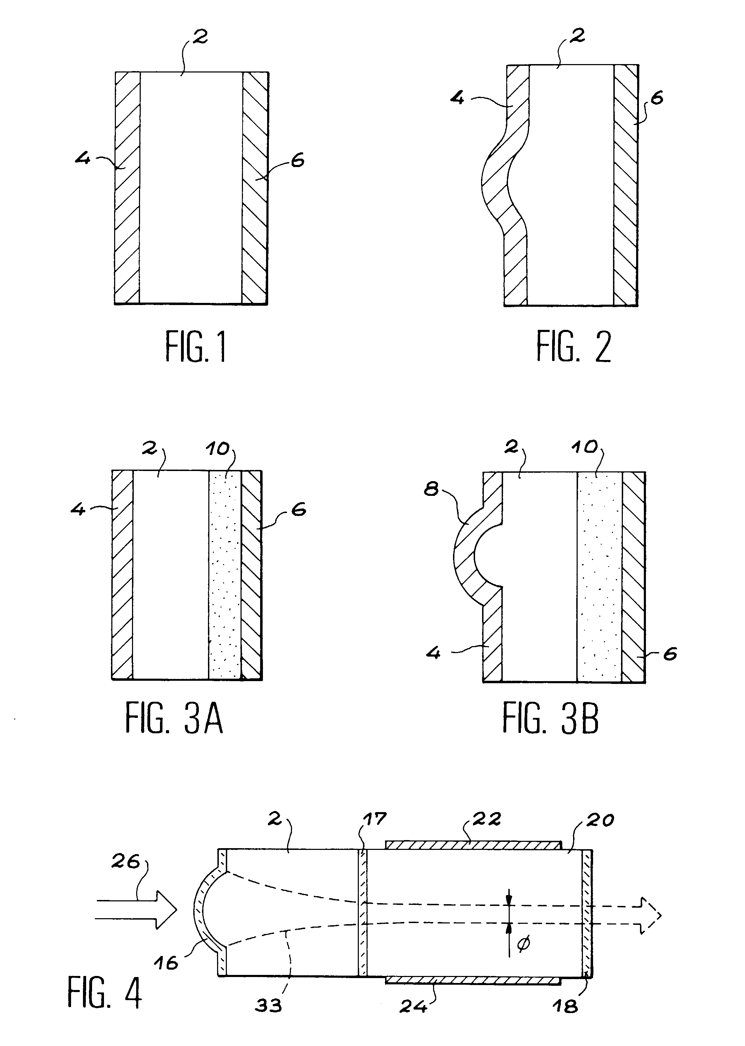

Les figures 1 et 2 ci-jointes représentent des structures désormais classiques de microlasers. La structure de la figure 1 correspond à une cavité microlaser plan-plan, la structure de la figure 2 correspond à une cavité microlaser plan-concave. On peut également réaliser des cavités microlaser biconcaves. Dans tous les cas, la structure de base consiste en un milieu actif laser 2, la cavité microlaser étant limitée par un miroir d'entrée 4 et un miroir de sortie 6. Ces cavités peuvent également incorporer d'autres éléments intracavités tels que par exemple un absorbant saturable déposé sous forme de couches minces, comme décrit dans les documents EP-653 824 (US-A-5 495 494).

Un certain nombre de modes transverses ou longitudinaux peuvent osciller à l'intérieur d'une telle cavité laser, quelle qu'en soit la structure. Ces modes résonnent à des fréquences différentes et la présence de plusieurs modes dans la cavité résulte en un étalement spectral du faisceau émis par le microlaser.

Il est possible de calculer l'épaisseur du milieu actif laser 2 ou de la cavité microlaser, de manière à n'obtenir qu'un seul mode longitudinal : un tel calcul et des exemples sont donnés dans le document EP-653 824.

En général, le faisceau laser obtenu présente plusieurs modes transverses. Il en résulte une divergence du faisceau laser émis par le microlaser. Pour obtenir un faisceau de qualité, moins divergent, il se pose donc le problème de supprimer, ou de diminuer, le niveau ou l'intensité des modes transverses.

Par ailleurs, le rendement de pompage d'une cavité microlaser est faible, en particulier dans le cas d'une cavité stable (par exemple : plan-concave).

Enfin, d'une manière générale, il se pose aussi le problème d'abaisser le seuil de fonctionnement microlaser, c'est-à-dire la puissance incidente nécessaire au fonctionnement du microlaser.

### Exposé de l'invention

L'invention a pour objet un microlaser présentant, par rapport aux microlasers connus, un faisceau de meilleur qualité (en particulier, de divergence moindre), un meilleur rendement de pompage (en particulier, dans le cas d'une cavité stable), et un seuil de fonctionnement plus faible.

L'invention a pour objet un microlaser comportant un milieu actif solide, un miroir d'entrée et un miroir de sortie délimitant une cavité microlaser, et des moyens de pompage de la cavité comportant au moins un laser semi-conducteur à cavité verticale.

Le pompage du microlaser n'étant plus assuré par une diode laser classique, par exemple du type III-V, mais par un laser semi-conducteur à cavité verticale.

Les lasers semi-conducteurs à cavité verticale (en abrégé : VCSEL) sont des lasers qui utilisent un matériau semi-conducteur à puits quantiques multiples comme milieu actif. L'épaisseur du milieu actif laser est très faible, car il ne contient que quelques puits quantiques. Ce milieu actif est encadré par deux miroirs réalisés aussi par des couches minces successives de semi-conducteurs. L'axe de la cavité laser est perpendiculaire à la structure en couches, d'où la dénomination de lasers "à cavité verticale". Le faisceau laser est issu de la surface de la puce laser.

L'utilisation des VCSEL présente certains inconvénients. Tout d'abord, la densité de puissance émise par un VCSEL est faible : typiquement, elle est d'environ 50 mW pour un faisceau de 30 µm de diamètre, tandis qu'une diode laser "classique" émet, pour une même surface, une puissance d'environ 1 W. De plus et comme les diodes lasers, les VCSEL sont sensible au "feed-back" (rétroaction) : il s'agit du retour de la lumière émise par le VCSEL sur lui-même, ce qui perturbe sa stabilité (on peut constater, en particulier, des instabilités dans le temps de la largeur spectrale du faisceau émis par le VCSEL).

Malgré ces inconvénients, on constate qu'un faisceau laser émis par un microlaser pompé par un VCSEL présente de bonne propriétés.

Un microlaser pompé par un VCSEL présente un faisceau de meilleure qualité qu'un microlaser pompé par une diode classique : la divergence du faisceau est moindre.

De plus, le seuil de fonctionnement du microlaser est abaissé : la largeur spectrale, en émission, d'un VCSEL est plus faible que celle d'une diode classique, et comparable à la largeur spectrale de la bande d'absorption du microlaser (Δλ_{abs}≈1 nm pour un microlaser YAG ; Δλ_{émission}≈0,3 nm pour un VCSEL et ≈ 3 nm pour une diode de pompage de puissance 1 W).

Enfin, la géométrie du faisceau émis par un VCSEL est circulaire et symétrique, et non pas rectangulaire et ne présentant pas d'anamorphose comme les diodes lasers. Ceci permet un recouvrement plus aisé du faisceau émis par le VCSEL et du mode fondamental, à structure circulaire, du microlaser. En particulier, dans le cas d'une cavité microlaser stabilisée, la forme du faisceau émis par un VCSEL est très bien adaptée au pompage du mode fondamental. Le VCSEL émet une densité de puissance plus faible qu'une diode laser classique, mais cette densité est mieux répartie pour le pompage du mode fondamental du microlaser. Il en résulte un meilleur rendement de pompage et un meilleur pompage du mode fondamental.

En outre, la combinaison d'un microlaser et d'un VCSEL présente les avantages suivants.

Le microlaser est fabriqué par un empilement de couches successives de nature et de fonction différentes (miroir, milieu actif, absorbant saturable, ...). On utilise des substrats de grandes dimensions (de 1 à 2 pouces de diamètre, soit 25,4 mm à 50,8 mm) et on peut fabriquer, à partir d'un substrat, plusieurs centaines de microlasers. A la fin, une étape de découpe et de montage permet d'isoler les puces et de les assembler avec les diodes lasers.

La fabrication des diodes lasers classiques, par exemple III-V, se fait aussi de façon collective. Elle se termine aussi par une phase de montage individuel des puces. Lorsqu'on réalise un microlaser pompé par diode laser, on double donc l'étape de montage, car on réalise deux étapes de montage individuel.

Au contraire, la fabrication des VCSEL met en oeuvre la formation de couches sur un substrat, et des étapes de gravures compatibles avec la fabrication collective. On fabrique donc des plaques de VCSEL qu'on peut aisément assembler avec les plaques de microlaser, et l'assemblage de ces plaques est ensuite découpé. On réalise donc une fabrication qui, du point de vue technologique, est plus simple.

Cette simplicité se répercute sur le coût total de la fabrication : on supprime une étape de montage, qui est une étape coûteuse. Ceci est d'autant plus intéressant que les microlasers peuvent être produits à l'aide de techniques issues de la microélectronique, dont la vocation est d'être mises en oeuvre de manière collective, pour la réalisation de nombreux composants.

Enfin, la structure VCSEL se prête aisément à la fabrication de réseaux à deux dimensions (2D). Au contraire, dans le cas de diodes lasers, la fabrication de barrettes est possible, mais la réalisation des diodes lasers selon un réseau bidimensionnel est complexe. Dans le cas des VCSEL, les techniques de fabrication exposées ci-dessus conduisent d'abord à des réseaux bidimensionnels de VCSEL.

En résumé, la structure de microlasers selon l'invention permet d'améliorer la qualité du faisceau laser émis par le microlaser, en particulier par amélioration des qualités géométriques du faisceau émis par le microlaser, par augmentation du rendement différentiel des microlasers, et par diminution du seuil de fonctionnement (en puissance incidente) du microlaser.

De plus, la structure du microlaser selon l'invention est compatible avec une fabrication collective simple de l'ensemble constitué par les moyens de pompage et par la cavité microlaser.

La structure de microlaser selon l'invention est compatible avec une cavité microlaser fonctionnant en continu, ou en mode impulsionnel déclenché, actif ou passif.

Il est possible de coupler un microlaser avec un réseau de VCSEL. Ceci est facilité, comme expliqué ci-dessus, par le procédé de fabrication des VCSEL.

Des moyens de focalisation peuvent être prévus entre le VCSEL, ou le réseau de VCSEL, et la cavité microlaser.

### Brève description des figures

D'autres caractéristiques et avantages de l'invention ressortiront mieux de la description qui va suivre, donnée à titre purement illustratif et non limitatif, en référence aux figures annexées, dans lesquelles :
- les figures 1 et 2, déjà décrites, présentent des cavités microlasers selon l'art antérieur,
- les figures 3A et 3B représentent une cavité microlaser avec absorbant saturable intracavité, sans (Fig. 3A) et avec (Fig. 3b) microlentille pour stabiliser la cavité,
- la figure 4 est un exemple de microlaser à déclenchement actif,
- la figure 5 représente une structure à puits quantiques multiples,
- la figure 6 représente les niveaux d'énergie d'une structure à puits quantiques multiples,
- la figure 7 représente schématiquement un VCSEL,
- les figures 8 à 11 représentent des microlasers selon l'invention.

### Description détaillée de modes de réalisation de l'invention

D'une manière générale, un microlaser selon l'invention comporte un milieu actif solide, à l'intérieur d'une cavité microlaser délimitée par un miroir d'entrée et un miroir de sortie.

Le matériau actif laser consiste essentiellement en un matériau de base dopé avec des ions actifs laser.

Le matériau de base peut être un matériau cristallin, choisi par exemple parmi l'un des matériaux suivants : YAG (Y₃Al₅O₁₂), LMA(LaMgAl₁₁O₁₉), YVO₄, YSO (Y₂SiO₅), YLF (YLiF₄) ou GdVO₄, etc. Des critères de choix pour l'un ou l'autre de ces matériaux sont donnés dans le document EP-653 824 (document US-5 495 494). Ce document donne également les indications sur le choix de l'épaisseur e du milieu actif laser, en particulier pour obtenir un laser monomode ; typiquement, l'épaisseur du milieu actif est de l'ordre de :
- 750 µm pour un milieu actif YAG,
- 500 µm pour un milieu actif YVO₄,
- 150 µm pour un milieu actif LMA.

En ce qui concerne les ions dopants, on choisit en général du néodyme (Nd) pour une émission laser autour de 1,06 µm. On peut également choisir de l'erbium (Er) ou un codopage erbium-ytterbium (Er+Yb) pour une émission autour de 1,5 µm. Pour une émission autour de 2 µm, on choisit du thulium (Tm) ou de l'holmium (Ho) ou un codopage thulium-holmium. Le dopage à l'ytterbium seul permet d'obtenir une émission à 1,03 µm.

On peut également réaliser un milieu actif constitué d'un verre, dopé par exemple à l'erbium et à l'ytterbium (émission à 1,55 µm) comme expliqué dans l'article de P. Thony et al., intitulé "1,55 µm wavelength CW microchip laser", Proceedings of Advanced Solid-State Laser 1996, San Francisco.

Le milieu actif laser est donc diélectrique.

Un autre élément peut également être présent à l'intérieur de la cavité microlaser selon l'invention : il s'agit d'un élément absorbant saturable 10 (figures 3A. et 3B). De manière particulièrement avantageuse, l'absorbant saturable peut être une couche mince de matériau absorbant saturable, directement déposée sur le milieu actif solide 2. Dans la mesure où ce dernier a une structure cristalline, un procédé de réalisation particulièrement intéressant, pour cette couche d'absorbant saturable, est l'épitaxie en phase liquide. Dans ce cas, la couche 16 est composée d'un matériau de base, identique à celui du milieu actif solide 2, et dopé avec des ions lui conférant des propriétés d'absorbant saturable, par exemple des ions chrome (Cr⁴⁺) ou erbium (Er³⁺). Ainsi, on peut obtenir une couche d'absorbant saturable, directement déposée sur le milieu actif laser, et d'épaisseur comprise entre quelques µm et environ 400 µm. Toutes les informations nécessaires à la réalisation d'une telle couche d'absorbant saturable sont données dans le document EP-653 824 (US-5 495 494). En particulier, il est également possible de réaliser un dépôt d'absorbant saturable de part et d'autre du milieu actif laser 2, et d'obtenir une cavité microlaser avec deux couches de matériau absorbant saturable directement déposées sur le milieu actif laser. Il est également possible de réaliser des microlentilles 8 en un matériau transparent (par exemple en silice) sur la surface du matériau actif laser 2. Là encore, toutes les informations nécessaires à la réalisation de ces microlentilles sont données dans le document EP-653 824. Les microlentilles permettent de stabiliser la cavité microlaser.

Le matériau actif laser d'une cavité microlaser selon l'invention peut être également associé à des moyens de déclenchement actifs, disposés à l'intérieur de la cavité. Ce mode de réalisation est illustré sur la figure 4, où la référence 2 désigne toujours le milieu actif laser, et où la cavité est limitée par des miroirs d'entrée 16 et de sortie 18 du milieu actif laser. En fait, un miroir intermédiaire 27 délimite deux cavités : une première cavité résonnante est constituée par le milieu actif laser, et une seconde cavité résonnante par un matériau 20 possédant un indice susceptible de varier en fonction de perturbations extérieures. Ce matériau 20 peut être un matériau électrooptique, tel que du LiTaO₃, auquel on applique une différence de potentiel à l'aide de deux électrodes de contact 22, 24. Un faisceau de pompage 26 est dirigé sur le miroir d'entrée 16. Le miroir 16, concave, permet d'assurer une réduction de la taille du faisceau laser dans le milieu électrooptique 20. Les conditions relatives au rayon de courbure de ce miroir, et le procédé pour réaliser la structure de la figure 4 sont donnés dans le document FR-95 00767 (US-08-587 477).

D'autres éléments optiques peuvent être prévus à l'intérieur de la cavité du microlaser : par exemple, un cristal non linéaire doubleur ou tripleur de fréquence, ou bien un oscillateur paramétrique optique.

Que la cavité microlaser incorpore un absorbant saturable, ou un moyen de déclenchement actif de la cavité, ou un élément optiquement non linéaire (doubleur, tripleur de fréquence, OPO), le faisceau issu de la cavité microlaser selon l'invention bénéficie toujours des propriétés avantageuses liées au pompage par un laser semi-conducteur à cavité verticale.

Les lasers à semi-conducteur et à cavité verticale utilisent une structure à puits quantiques multiples comme milieu actif.

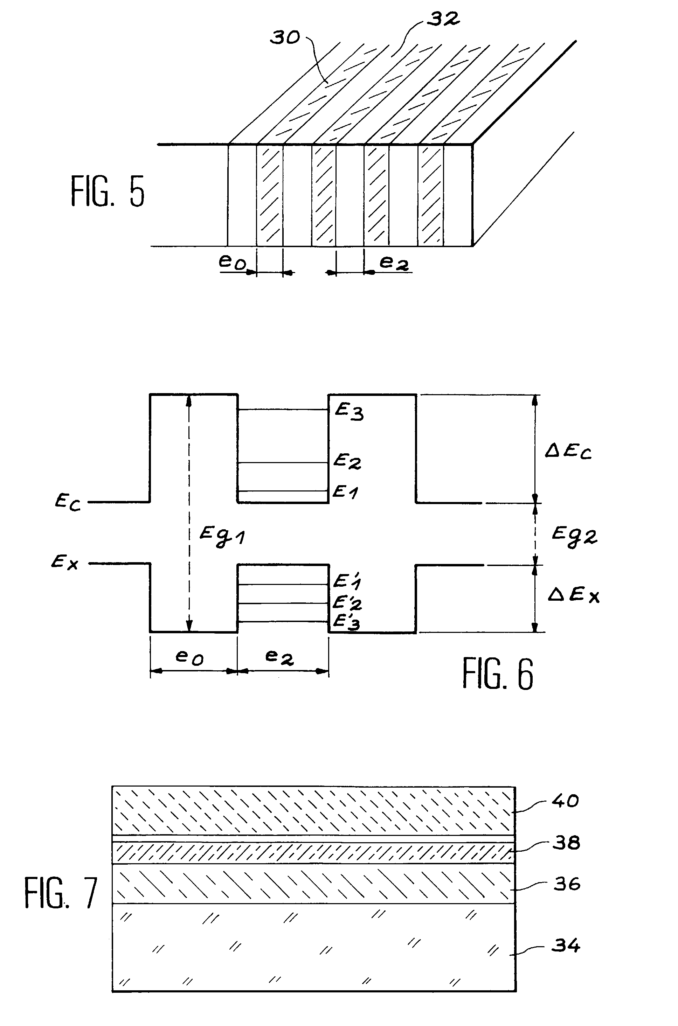

Comme illustré sur la figure 5, une telle structure est un arrangement périodique de couches 30 de matériau à grande largeur de bande interdite (par exemple : GaAlAs) et de couches 32 de matériau semi-conducteur à petite largeur de bande interdite (par exemple : GaAs). De telles structures peuvent être obtenues par épitaxie en phase vapeur, à partir de composés organométalliques, par exemple MOCVD (dépôt chimique organométallique en phase vapeur), ou par épitaxie par jet moléculaire. Avec ces techniques, il est possible d'ajuster le dépôt et l'épaisseur de couches de matériau semi-conducteur, avec une précision de l'ordre de la distance interatomique. Ainsi, l'épaisseur e₀ de la couche 30 et l'épaisseur e₂ de la couche 32 peuvent être ajustées de manière très précise.

Du point de vue énergétique, une telle structure peut être caractérisée schématiquement de la manière représentée sur la figure 6. Plus précisément, cette figure représente le profil des puits de potentiel et les niveaux d'énergie discrets pris par les porteurs respectivement dans les bandes de conduction et de valence (respectivement : électrons et trous). Lorsqu'une couche mince épitaxiée de matériau semi-conducteur, à bande interdite faible (couche d'épaisseur typiquement de l'ordre de 10 nm) est entourée de deux couches de matériau à bande interdite plus grande (telles les couches 30 sur la figure 5), les électrons et les trous de matériau à bande interdite faible sont confinés dans des puits de potentiel à une direction.

Le mouvement d'un électron dans un puits créé dans la bande de conduction (de hauteur ΔE_{c}) est quantifié dans des états permis discrets, d'énergie E₁, E₂, E₃, ... De même, le mouvement d'un trou dans un puits créé dans la bande de valence ΔE_{V} est quantifié en états permis discrets, d'énergie E'₁, E'₂, E'₃.

Lorsque l'épaisseur du matériau à petite bande interdite varie, les états d'énergie pris par les porteurs varient également. La longueur d'émission des structures à puits quantiques multiples peut donc être ajustée par le choix de la nature et de l'épaisseur des couches de matériau semi-conducteur.

Une telle structure constitue, dans un laser semi-conducteur à cavité verticale, le milieu actif. Ce milieu actif est inséré entre deux miroirs de Bragg. Chaque miroir, monolithique, peut être réalisé à la longueur d'onde λ en employant un empilement de couches i et j de matériau à haut et bas indices optiques nᵢⱼ d'épaisseur (λ/4)nᵢⱼ. De telles couches peuvent être réalisées par épitaxie de composé semi-conducteur dont on contrôle la composition et l'épaisseur. La réflectivité de ces miroirs peut être ajustée en fonction de la longueur d'onde d'émission du VCSEL. La cavité peut être pompée électriquement à l'aide d'électrodes rapportée de part et d'autre de la structure.

Des structures de laser semi-conducteur, à cavité verticale sont données dans K. IGA et al., "Surface emitting semiconductor laser and Arrays", pages 87-117 (1993, Academic Press, San Diego).

Un exemple d'une telle structure est illustré sur la figure 7. Cette structure comporte un substrat 34 InP dopé p, sur laquelle est formée une couche 36 en InAlAs dopé p, d'épaisseur 0,4 µm. Sur cette couche est réalisée la structure 38 à puits quantiques multiples, faisant intervenir 10 alternances de couches InGaAs de 9 nm d'épaisseur et InAlAs d'épaisseur 20 nm. Enfin, l'ensemble est recouvert d'une couche 40 InAlAs dopé n, d'épaisseur 0,3 µm.

D'une manière générale, l'espacement entre les miroirs d'un VCSEL est de l'ordre de 1 à 2 µm : il en résulte que les modes d'un tel laser sont bien séparés (intervalle spectral très grand).

Typiquement, le faisceau émis par un VCSEL est circulaire, de diamètre égal à environ 20 µm, présente une divergence d'environ 7°, et une largeur spectrale de quelques dixièmes de nanomètres (par exemple 0,3 nm).

Un VCSEL à base de AlGaAs peut émettre quelques milliwatts à une longueur d'onde comprise sensiblement entre 800 et 850 nm, dans un faisceau à section circulaire, de diamètre approximativement 8 µm.

Un VCSEL avec un matériau à base de InGaAs émet une puissance d'environ 50 mW à environ 980 nm, pour un faisceau circulaire de diamètre environ égal à 30 µm. Les puissances données ci-dessus correspondent aux puissances d'émission en continu.

Le diamètre des VCSEL varie de quelques µm jusqu'à 150 µm.

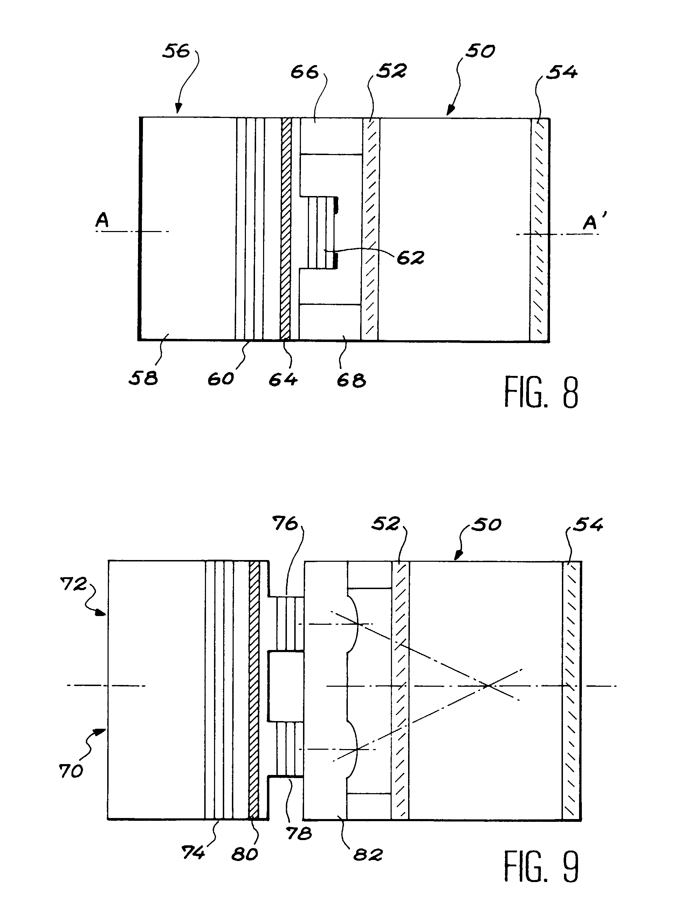

La figure 8 représente un mode de réalisation d'un microlaser selon l'invention. La cavité microlaser 50 est du type de celle décrite ci-dessus, avec un milieu actif laser et, éventuellement, d'autres éléments intracavités. La cavité est limitée par un miroir d'entrée 52 et un miroir de sortie 54. Le microlaser est pompé par un laser semi-conducteur à cavité verticale 56 qui comporte un substrat 58, un miroir d'entrée 60 et un miroir de sortie 62. La zone active (à structure de puits quantiques multiples) est désignée par la référence 64. Le VCSEL 56 émet un faisceau suivant une direction perpendiculaire à la zone active 64, et se situant donc dans l'axe AA' de la cavité microlaser. Les deux éléments sont avantageusement couplés mécaniquement, par exemple avec des espaceurs 66, 68.

La figure 9 représente deux lasers semi-conducteurs à cavité verticale 70, 72, ayant une structure commune formant miroir d'entrée 74, et ayant chacun un miroir de sortie 76, 78. La zone active 80 est également formée par un ensemble de couches communes aux deux VCSEL. Chacun des VCSEL émet un faisceau suivant une direction perpendiculaire à la zone active 80 et peut pomper une partie du milieu actif du microlaser 50. Par ailleurs, des moyens microoptiques 82 peuvent également être prévus, permettant de focaliser les faisceaux de pompage en un point M à l'intérieur de la cavité microlaser 50. Ces moyens 82, peuvent être constitués par un réseau de microlentilles, correspondant au réseau de VCSEL utilisés pour pomper le microlaser 50. De tels microlentilles, et leur procédé de réalisation, sont décrites dans le document EP-523 861 (MITSUI).

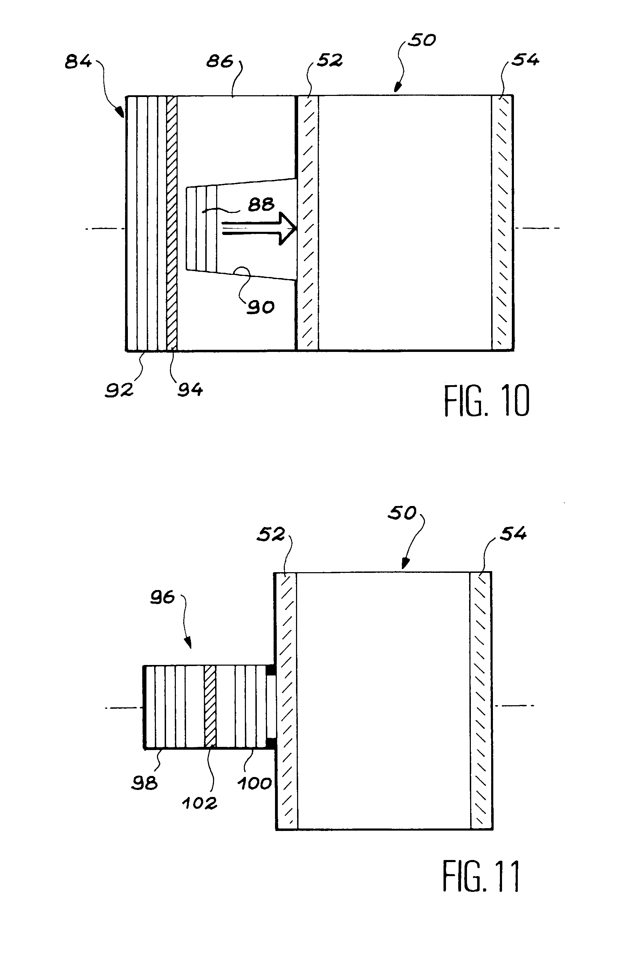

La figure 10 représente une autre structure de microlasers selon l'invention. Des références numériques identiques aux figures précédentes désignent les mêmes éléments. Un VCSEL 84 pompe le microlaser. Ce VCSEL présente un substrat 86 qui est gravé. Le miroir de sortie 88 est déposé au fond de la zone 90 obtenue par gravure. Le miroir d'entrée et la zone active du VCSEL 84 sont désignés respectivement par les références 92, 94.

La figure 11 représente un microlaser 50 pompé par un VCSEL 96 qui a été décollé de son substrat de croissance, après gravure complète. Ce VCSEL est ensuite reporté sur la tranche du microlaser solide, puis est découpé pour donner la puce de la figure 11.

Le couplage d'un VCSEL avec un microlaser permet d'accroître le rendement différentiel du microlaser, et permet de diminuer le seuil laser en puissance incidente.

En effet, la symétrie circulaire ou faisceau émis par le VCSEL lui permet de s'adapter au mode fondamental du microlaser, qui a lui-aussi une structure circulaire. Le diamètre du faisceau de VCSEL est inférieur à celui du mode fondamental du microlaser (qui a un diamètre en général de l'ordre de 100 µm, dans une cavité plan-plan). Par conséquent, toute l'énergie du faisceau de pompage fournie par le VCSEL sera contenue à l'intérieur du faisceau du microlaser. De plus, la divergence faible du faisceau du VCSEL lui permet de rester dans le mode fondamental du microlaser sur toute la longueur de celui-ci. Il en résulte un très bon recouvrement spatial du mode fondamental du microlaser et de son faisceau de pompage : on augmente ainsi l'efficacité de pompage par rapport au cas où on pompe la cavité microlaser avec une diode laser classique. Dans ce dernier cas, en effet, les faisceaux de diodes lasers sont plus larges que le mode fondamental de la cavité. Par conséquent, le faisceau de pompage est alors absorbé dans des zones favorisant des modes transverses autres que le mode fondamental de la cavité microlaser. Ce phénomène est encore plus sensible dans les cavités plan-concave (figure 2) que dans les cavités plan-plan (figure 1). En effet, le mode fondamental du microlaser est de taille plus petite (de l'ordre de 30 µm de diamètre) dans le cas d'une cavité stable, plan-concave, que dans une cavité plan-plan. De même, le niveau de perte des modes supérieurs introduits par la géométrie de la cavité est plus faible dans le cas d'une cavité plan-concave que dans le cas d'une cavité plan-plan. Par conséquent, dans une cavité plan-concave, le pompage par diode laser classique favorise encore plus l'apparition de modes transverses autres que le mode fondamental dans les cavités microlasers. Le pompage par VCSEL d'une cavité microlaser stabilisée est extrêmement avantageux, car, de cette manière, le diamètre du faisceau circulaire du VCSEL peut être toujours adapté au pompage du mode fondamental de la cavité stabilisée. Ainsi, une cavité stabilisée dont le mode fondamental est de l'ordre de 30 µm peut être pompée par un VCSEL dont le faisceau a un diamètre de 20 µm à 30 µm.

Le fait que la largeur spectrale du faisceau émis par un VCSEL soit relativement faible (quelques dixièmes de nanomètres) permet également d'accroître l'efficacité de pompage. Un matériau comme le YAG:Nd (de même que les cristaux ordonnés dopés aux terres rares) présente une raie d'absorption assez fine pour la longueur d'onde du faisceau de pompage (largeur à 808 nm : 1 nm). Un spectre de pompage de largeur fine peut donc être entièrement contenu dans la raie d'absorption du cristal (en particulier du YAG:Nd à 808 nm). Une absorption plus élevée est donc atteinte, ainsi qu'une meilleure efficacité de pompage.

Enfin, le pompage d'un microlaser par VCSEL permet d'améliorer la qualité du faisceau émis par le microlaser. En effet, avec un microlaser dans la cavité résonnante et stabilisé par des effets de gain (le faisceau laser se crée localement là où il y a suffisamment de gain) la forme du faisceau laser est déterminée en partie par la forme du faisceau de pompage. Dans ce cas, une bonne qualité du faisceau de pompage induit une bonne qualité du faisceau laser. En général, le faisceau laser s'adapte au faisceau de pompage en remplissant l'espace dans la cavité là où le gain est suffisant pour permettre une oscillation. Cet espace est rempli par des modes lasers. Si le volume où le gain est suffisant, c'est-à-dire le volume où le seuil laser est dépassé, est supérieur au volume occupé par le mode fondamental, des modes transverses d'ordre supérieur apparaissent. Si le volume, où le gain est suffisant, est égale ou plus petit que le volume du mode fondamental, alors il y n'y a que le mode fondamental qui est excité et qui oscille. Avec un VCSEL, on sélectionne le mode fondamental de la cavité microlaser et on augmente donc la cavité spatiale du faisceau laser.

Les techniques de réalisation de cavités microlasers, avec absorbant saturable ou moyen de déclenchement actif de la cavité, ont été décrites dans le document EP-653 824 et dans le document FR-95 00767 (US-08 587 477).

Ces procédés mettent en oeuvre la réalisation de plaques de milieu actif, munies du moyens de déclenchement, actifs ou passifs, et des couches de miroir d'entrée et de sortie des cavités microlasers. Les cavités individuelles sont obtenues par découpe d'une telle plaque.

Avant découpe, on associe la plaque de milieu actif laser, munie de ses moyens de déclenchement et des couches de miroirs, à une plaque de VCSEL.

Les VCSEL sont fabriqués par épitaxie de matériau semi-conducteur sur un substrat, gravure des émetteurs, prise de contact électrique, et test des émetteurs. Il est intéressant d'utiliser, pour la gravure des VCSEL, un masque compatible avec celui utilisé pour la gravure des microlasers solides.

Des procédés de réalisation des VCSEL GAInAsP sont donnés dans K. IGA et al., page 87-117, "Surface emitting semiconductor laser and arrays", 1993.

D'autres matériaux possibles sont :
- GaAlAs-GaAs
- InGaAs-GdAs
- InGaAsP-InP
- InAlGaP-GaAs.

Une fois réalisée la plaque de VCSEL, l'étape suivante consiste à assembler les deux plaques : celle de VCSEL et celle du microlaser. Il est possible, par exemple, de réaliser un collage optique des deux plaquettes, avec ou sans espaceur.

L'ensemble obtenu, après association des plaquettes, peut être découpé avec une scie à lame diamantée ou gardé en l'état pour former un réseau à deux dimensions. On obtient ainsi un grand nombre de puces lasers avec leur source de pompage optique intégrée.

Des contacts sont ensuite pris pour alimenter le VCSEL. Ce dispositif à microlaser solide est donc directement utilisable avec une source de courant électrique, tout en conservant un faible coût pour une fabrication de masse.

Un microlaser selon l'invention, pompé par VCSEL, peut être utilisé dans le domaine de la télémétrie à modulation de fréquence et à sécurité oculaire. D'autres applications concernent des domaines aussi variés que l'industrie, l'automobile, ou l'instrumentation scientifique.

## Revendications

1. Microlaser comportant un milieu actif solide, un miroir d'entrée (52) et un miroir de sortie (54), et des moyens de pompage comportant au moins un laser semi-conducteur à cavité verticale (56, 70, 72, 84, 96).

2. Microlaser selon la revendication 1, un dispositif microoptique de focalisation (82) étant inséré entre le laser semi-conducteur et la cavité du microlaser.

3. Microlaser selon la revendication 1, la cavité microlaser étant stabilisée.

4. Microlaser selon l'une des revendications 1 à 3, les moyens de pompage comportant un réseau (70, 72) de lasers à semi-conducteurs à cavité verticale.

5. Microlaser selon l'une des revendications 1 à 4, la cavité microlaser comportant en outre des moyens (10) de déclenchement passif de la cavité.

6. Microlaser selon l'une des revendications 1 à 4, la cavité microlaser comportant en outre des moyens (20, 22, 24) de déclenchement actif de la cavité.

7. Microlaser selon l'une des revendications précédentes, le laser semi-conducteur à cavité verticale étant à base de InAlAs sur substrat InP, ou à base de AlGaAs sur substrat AsGa, ou à base de InGaAsP sur InP, ou à base de InGaAs sur AsGa, ou à base de InAlGaP sur AsGa.

8. Microlaser selon l'une des revendications 1 à 7, caractérisé en ce que le substrat du VCSEL est gravé en forme de lentille.

9. Microlasers selon l'une des revendications 1 à 8, caractérisé par le fait qu'il sont répartis en réseau à deux dimensions.
